# EUROPEAN PATENT APPLICATION

(11) **EP 1 939 952 A2**
(43) Date of publication of application: **02.07.2008**
(21) Application number: 07024999.0
(22) Date of filing: 21.12.2007
(51) Int. Cl.: H01L 51/52, H01L 27/32

(54) **Organic EL light-emitting apparatus and method of manufacturing the same**

(30) Priority: 28.12.2006 JP 2006356138
(71) Applicant: Yamagata Promotional Organization for Industrial Technology, Yamagata-shi, Yamagata 990-2473 (JP)
(72) Inventor: Kajikawa, Fujio, Yonezawa-shi Yanagata 9921128 (JP); Suzuki, Joji, Yonezawa-shi Yanagata 9921128 (JP)
(74) Representative: HOFFMANN EITLE

(57) **Abstract**

The present invention provides an organic EL light-emitting apparatus that can compensate a voltage drop caused on a transparent electrode and that can prevent the occurrence of brightness unevenness caused by the voltage drop.

A transparent electrode 2, an organic light-emitting functional layer 5, and a back electrode 6 are successively laminated on a light-transmitting substrate 1, and a sealing member 9 for sealing the transparent electrode, the organic light-emitting functional layer, and the back electrode is provided so as to accommodate them between the substrate 1 and the sealing member 9. A conductive layer 10 is formed on the sealing member 9, and conductive columnar members 4 are interspersedly formed between the conductive layer 10 and the transparent electrode 2 in the plane direction of the substrate 1. Accordingly, electric power is supplied to the transparent electrode 2 from the conductive layer 10 through the conductive columnar members 4.

## Description

### BACKGROUND OF THE INVENTION

### 1. Field of the Invention

The present invention relates to an organic EL light-emitting apparatus that uses an organic EL (electroluminescence) element as a surface light-emitting source having relatively large area, and a method of manufacturing the same.

### 2. Description of the Related Art

Since an organic EL element has a high luminous efficiency by being driven with DC low voltage, and can be made light in weight and thin in size, it has been utilized for a flat panel display (FPD) in some portable apparatuses. Further, an apparatus utilizing the organic EL element as a surface light-emitting source, e.g., as a backlight of a liquid crystal display device, has been proposed.

On the other hand, the organic EL element can provide each color of light of R (red), G (green), and B (blue) by selecting a material used for a light-emitting functional layer. Therefore, white color or whitish color can also be obtained by using the aforesaid colors of light singly or in combination. Accordingly, if the organic EL element is configured as a surface light-emitting source (light-emitting panel) having relatively large area, the organic EL element can be utilized as light sources for a light-emitting poster for advertisement, illumination, and sign, and in addition to these, as a high-efficient light source that illuminates the inside of a room or inside of a vehicle.

In the above-mentioned organic EL element, electrons injected from a cathode and holes injected from an anode are recombined in the light-emitting functional layer through the application of DC voltage between the opposite electrodes, and the energy of the recombination excites a fluorescent material, whereby light is emitted. Therefore, it is necessary to take out the emission from the light-emitting functional layer to the outside, for which a transparent electrode is employed as at least one of the electrodes. An indium tin oxide (ITO) is generally used as the transparent electrode, for example.

The organic EL element is configured in such a manner that the above-mentioned transparent electrode made of ITO is formed on a substrate, which is basically transparent, a light-emitting functional layer composed of, for example, a hole transporting layer, an organic luminous layer, and an electron injecting layer is formed thereon, and a metal electrode is formed thereon. In this laminated structure, the transparent electrode generally constitutes an anode, and the metal electrode constitutes a cathode. A DC voltage is applied between both electrodes.

The ITO constituting the transparent electrode has an electrical resistivity of about 1 × 10⁻⁴ Ωcm, which is higher than that of a normal metal material by one to two digits. Therefore, when the EL element is used as a surface light-emitting source having large area, non-uniformity (luminance gradient) is produced on the luminous brightness due to voltage drop of the transparent electrode.

Specifically, it is said that the luminous brightness in the organic EL element is substantially proportional to the amount of electric current injected to a unit area of the element. Therefore, the luminous brightness is affected by the voltage drop of the ITO as the element is apart from an electric power supply point to the transparent electrode, which entails a problem that the brightness is reduced as the element is apart from the electric power supply point to the transparent electrode.

In order to overcome the aforesaid problem, materials, having reduced electric resistivity, for the transparent electrode represented by ITO have been proposed, but these proposals do not realize the incomparable reduction of the electric resistivity. Accordingly, when the organic EL element is used as the surface light-emitting source suitable for an illumination and having a large area, the problem of non-uniformity (luminance gradient) of the luminous brightness still remains.

In order to solve the above-mentioned problem, Japanese Patent Application Laid-Open No. 2002-156633 discloses a configuration in which an electrode formed of a low-resistant material in a lattice form is superimposed on a transparent electrode, and Japanese Patent Application Laid-Open No. 2000-91083 discloses a configuration in which conductive members formed in a ladder form are arranged so as to be parallel to one another and superimposed on a transparent electrode.

In the configurations disclosed in Japanese Patent Applications Laid-Open Nos. 2002-156633 and 2000-91083, the electrodes formed in a lattice form or the conductive members formed in a ladder form can compensate the voltage drop produced on the transparent electrode, whereby it can be expected that the occurrence of brightness unevenness is effectively prevented.

According to the light-emitting sources disclosed in Japanese Patent Applications Laid-Open Nos. 2002-156633 and 2000-91083, the lattice electrodes or conductive members in a ladder form are arranged on all over the surface of the transparent electrode. At the position where the lattice electrodes or the conductive members in a ladder form are arranged, light from the light-emitting functional layer is blocked by the lattice electrodes or the conductive members in a ladder form, or the position where the lattice electrodes or the conductive members in a ladder form are arranged becomes the non-emission area, so that the ratio of the area of the non-emission portion in the entire light-emitting panel is substantially increased. In other words, in the light-emitting sources disclosed in Japanese Patent Applications Laid-Open Nos. 2002-156633 and 2000-91083, extraction (take-out) efficiency of light emission from the light-emitting functional layer is poor, and there is still room for improvement on this point.

Further, according to the light-emitting sources in Japanese Patent Applications Laid-Open Nos. 2002-156633 and 2000-91083, the lattice electrodes or the conductive members in a ladder form block the light from the light-emitting functional layer, or the portion where the lattice electrodes or the conductive members in a ladder form becomes the non-emission area. Therefore, loss is produced in driving electric power supplied to the light-emitting source, and there is still room for improvement from the viewpoint of luminous efficiency.

### SUMMARY OF THE INVENTION

The present invention is made on the basis of the above-mentioned technical viewpoint, and its object is to provide an organic EL light-emitting apparatus that increases extraction efficiency of light emission by reducing the ratio of the area of the non-emission portion in the entire light-emitting panel, and a method of manufacturing the same. Further, another object of the present invention is to provide a light-emitting apparatus having increased luminous efficiency with respect to the driving electric power, and a method of manufacturing the same.

The invention accomplished for solving the foregoing problem is an organic EL light-emitting apparatus including a first electrode, an organic light-emitting functional layer, and a second electrode, those of which are successively laminated on a substrate, and a sealing member that seals the first electrode, the organic light-emitting functional layer and the second electrode so as to accommodate them between the substrate and the sealing member, wherein a main electric power supply point that supplies light emission drive current to at least one of the first electrode and the second electrode from a power supply unit and an auxiliary electric power supply point that supplies light emission drive current from the same electrode terminal of the power supply unit to at least one of the first electrode and the second electrode through the sealing member are provided.

An organic EL light-emitting apparatus according to a preferred embodiment of the present invention includes a first electrode, an organic light-emitting functional layer, and a second electrode, those of which are successively laminated on a substrate, and a sealing member that seals the first electrode, the organic light-emitting functional layer and the second electrode so as to accommodate them between the substrate and the sealing member, wherein the sealing member is made of a conductive material, or a conductive layer made of a conductive material is formed on the sealing member, conductive columnar members are interspersedly formed in the plane direction of the substrate between the sealing member or the conductive layer formed on the sealing member and the first electrode or the second electrode, wherein the light emission drive current from the power supply unit is fed to the first electrode or the second electrode, and the light emission drive current from the same electrode terminal of the power supply unit is fed to the first electrode or the second electrode through the sealing member or the conductive layer formed on the sealing member and the conductive columnar members.

In this case, it is desirable that an annular separator is formed to project from the first electrode so as to enclose the surroundings of the columnar members, and that an insulating gap portion for inhibiting the formation of an electrical conductive path by the material of the second electrode is formed between the columnar members and the second electrode when laminating the second electrode. Additionally, the separator is preferably provided with an overhang portion whose top projects toward the direction parallel to the substrate.

In one preferred embodiment, a gap holding member having a hardness greater than that of the conductive material constituting the columnar member is provided at an axial core portion of the columnar member, wherein the space between the substrate and the sealing member is maintained by the gap holding member. In another preferred embodiment, a gap holding member for maintaining the space between the substrate and the sealing member is provided separate from the columnar member.

A method of manufacturing an organic EL light-emitting apparatus according to the present invention is a method of manufacturing an organic EL light-emitting apparatus including a first electrode, an organic light-emitting functional layer, and a second electrode, those of which are successively laminated on a substrate, and a sealing member provided at its backside, the method including a step of forming the first electrode on the substrate, a step of interspersedly forming annular separators in the plane direction of the substrate so as to project from the first electrode in the normal direction of the substrate and forming a conductive columnar member on the first electrode at the center of each of the separators, a step of depositing an organic EL medium on the first electrode, the columnar member, and the separators so as to form the organic light-emitting functional layer, a step of forming the second electrode on the organic light-emitting functional layer, and a step of sealing the sealing member so as to accommodate the first electrode, the organic light-emitting functional layer, and the second electrode between the substrate and the sealing member, wherein an electric power supply point for the first electrode through the conductive columnar member is formed by the sealing member made of a conductive material or a conductive layer formed on the sealing member.

In this case, the annular separator is preferably formed to have an overhang portion that projects in the normal direction of the substrate and that has the top portion projecting in the direction parallel to the substrate.

According to the organic EL light-emitting apparatus having the above-mentioned configuration, the main electric power supply point and the auxiliary electric power supply point through the sealing member are formed for at least one of the first electrode and the second electrode between which the organic light-emitting functional layer is sandwiched. Therefore, the high electric resistivity of the material constituting the first electrode or the second electrode is compensated, whereby the occurrence of the luminance gradient can be reduced.

According to the organic EL light-emitting apparatus having the above-mentioned configuration, electric power is fed to the transparent electrode from the sealing member through the conductive columnar members interspersedly formed on the transparent electrode serving as the first electrode in the plane direction of the substrate. Therefore, it can effectively be prevented that the brightness unevenness is produced due to the high electric resistivity of the material, represented by, e.g., ITO, for the transparent electrode. Accordingly, when the organic EL element is used for a surface light-emitting source having relatively large area, the luminance gradient in which the brightness is reduced as the element is apart from the electric power supply point for the transparent electrode can effectively be prevented.

According to the organic EL light-emitting apparatus having the above-mentioned configuration, the degree of blocking the light from the light-emitting functional layer can extremely be reduced, like the light-emitting sources disclosed in Japanese Patent Applications Laid-Open Nos. 2002-156633 and 2000-91083 in which lattice electrode or electrodes in a ladder form are arranged all over the surface of the transparent electrode. Accordingly, the extraction (take-out) efficiency of light emission from the light-emitting functional layer can remarkably be enhanced.

In addition, since the annular separators are formed to project from the transparent electrode so as to enclose the surroundings of the columnar members, the formation of an electrical conductive path between the columnar members and a back electrode serving as the second electrode can be prevented when forming the back electrode. Therefore, the short-circuit between the columnar members and the back electrode can be prevented when manufacturing the organic EL light-emitting apparatus of this type having relatively large area, whereby an incidence rate of defect can remarkably be reduced.

### BRIEF DESCRIPTION OF THE DRAWINGS

FIG. 1 is an enlarged sectional view of an essential part of an organic EL light-emitting apparatus at an initial stage of a manufacturing process according to the present invention;
FIG. 2 is a plan view of the essential part viewed from the top;
FIG. 3 is an enlarged sectional view of an essential part in a process subsequent to the manufacturing process shown in FIG. 1;
FIG. 4 is a plan view of the essential part viewed from the top;
FIG. 5 is an enlarged sectional view of an essential part in a process subsequent to the manufacturing process shown in FIG. 3;
FIG. 6 is a plan view of the essential part viewed from the top;
FIG. 7 is an enlarged sectional view of an essential part in a process subsequent to the manufacturing process shown in FIG. 5;
FIG. 8 is a sectional view showing a basic configuration of an organic EL light-emitting apparatus obtained by the manufacturing processes shown in FIGS. 1 to 7;
FIG. 9 is a plan view showing the arrangement example of an electric power supply point to a transparent electrode formed on the substrate;
FIG. 10 is an enlarged sectional view of an essential part of an organic EL light-emitting apparatus according to a second embodiment of the present invention at an initial stage of a manufacturing process;
FIG. 11 is an enlarged sectional view of an essential part of an organic EL light-emitting apparatus according to a third embodiment of the present invention at an initial stage of a manufacturing process;
FIG. 12 is an enlarged sectional view of an essential part of an organic EL light-emitting apparatus according to a fourth embodiment of the present invention at an initial stage of a manufacturing process;
FIG. 13 is a plan view of the essential part viewed from the top;
FIG. 14 is an enlarged sectional view showing a state of an organic EL light-emitting apparatus during the manufacturing process according to a fifth embodiment of the present invention; and
FIG. 15 is a sectional view showing a basic configuration of an organic EL light-emitting apparatus according to the fifth embodiment.

### DESCRIPTION OF THE PREFERRED EMBODIMENTS

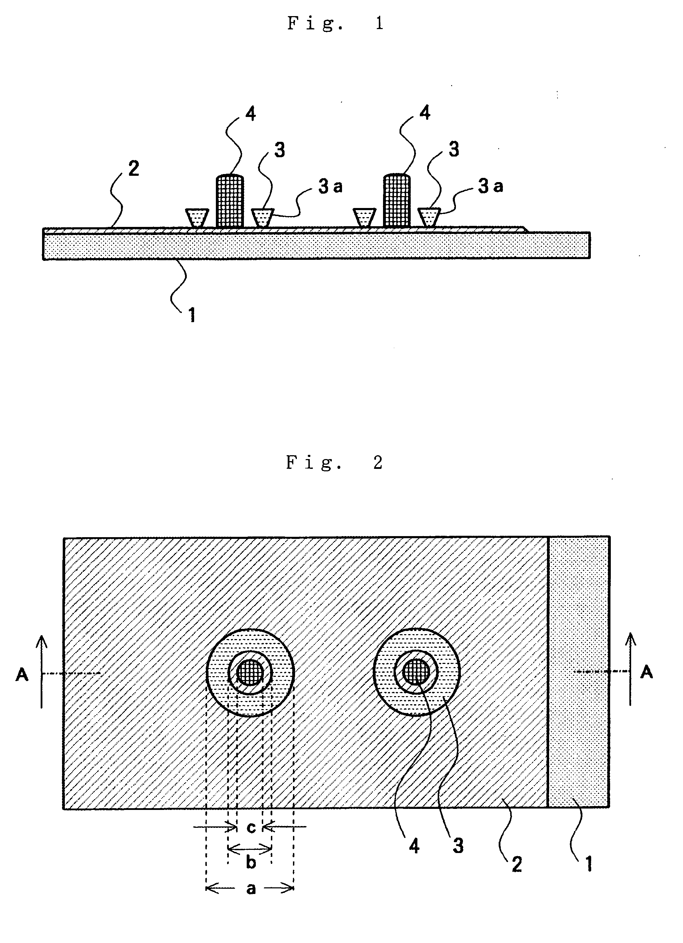

An organic EL light-emitting apparatus according to the present invention will be explained with reference to the embodiment shown in the drawings. Firstly, FIGS. 1 to 8 show processes of manufacturing the organic EL light-emitting apparatus according to the first embodiment.

FIG. 1 is an enlarged sectional view of an essential part of the organic EL light-emitting apparatus at an initial stage of the manufacturing process, and FIG. 2 shows the same essential part viewed from the top. Specifically, FIG. 1 corresponds to the sectional view seen in the direction of an arrow from A-A line in FIG. 2.

As shown in FIGS. 1 and 2, the organic EL light-emitting apparatus is formed on a substrate 1 made of a transparent or semitransparent material such as a glass or the like or a light-transmitting resinous material. The substrate 1 has a thickness of about 0.1 to 10 mm, which thickness is selected considering the mechanical strength, weight, etc. In general, suitably the thickness of the substrate 1 is approximately 0.5 to 5 mm.

As shown in FIGS. 1 and 2, a transparent electrode 2 that functions as an anode electrode serving as a first electrode is formed on one surface, i.e., on the upper surface, of the substrate 1. ITO is suitably used for the transparent electrode 2 as described above, but metal oxides such as indium zinc oxide or zinc oxide can also be employed. The thickness of the transparent electrode 2 is set to 80 to 400 nm, and more preferably to 100 to 200 nm, in order to secure transparency and conductivity.

The transparent electrode 2 can be formed on the substrate 1 by a method generally used, such as a sputtering method, ion plating method, deposition, or the like.

Insulating separators 3 are interspersedly formed on the transparent electrode 2 in the plane direction of the substrate 1. In FIGS. 1 and 2, the portion including two separators is schematically illustrated as enlarged. The separator 3 is configured to have an overhang portion 3a that annularly projects in the normal direction of the substrate 1, and has the top portion projecting in the direction parallel to the substrate 1. Specifically, the separator 3 is formed to have its section in substantially inverted isosceles trapezoidal shape as shown in FIG. 1.

One preferable method of forming the separator 3 having the above-mentioned structure will be described below. Specifically, a negative photoresist whose transmittance of UV ray is intentionally reduced is coated on the transparent electrode 2, and prebaked. The thickness in this case is set to about 3 µm. UV ray is irradiated to expose the position where the separator 3 is to be formed through a mask having a light-transmitting slit. At this time, since the photoresist has the reduced transmittance of UV ray, the difference in solubility to a developer occurs in the depth direction.

Accordingly, when alkali developer is sprayed to the substrate 1 on which the photoresist is prebaked, the separator 3 having the overhang portion 3a is formed to project from the transparent electrode 2 because of the difference in development progressing property. Since the sectional shape of the separator 3 becomes substantially an inverted isosceles trapezoid as described above, an insulating gap portion that prevents the formation of an electrical conductive path between a later-described conductive columnar member and a later-described back electrode can be formed when forming the back electrode.

Subsequently, a conductive columnar member 4 is formed on the transparent electrode 2 at the center of the annular separator 3. The columnar member 4 is preferably made of a conductive material such as a silver paste or carbon paste. In this case, a technique is employed in which an unillustrated positioning mark formed before hand on the substrate 1 is read by an image recognizing apparatus in order to position a conductive ejection nozzle that forms the columnar member 4. Thus, the columnar member 4 can be formed substantially at the center of the annular separator 3.

The outer diameter a of the separator 3 annularly formed in the present embodiment is set to about 10 µm to 10 mm. The internal diameter b of the separator 3 and the diameter of the columnar member 4 arranged at the center of the separator 3 are appropriately set on the basis of the setting of the outer diameter a of the separator 3.

When the diameter a of the separator 3 is set to be less than 10 µm, the diameter c of the columnar member 4 should inevitably be set to be small. Therefore, this requires the enhancement in arrangement precision of the columnar member 4 to the separator 3, and further, it becomes difficult to obtain satisfactory feeding effect by the columnar member 4. When the diameter a of the separator 3 exceeds 10 mm, the non-emission area of this portion is increased, and from this viewpoint, the diameter a should be held down.

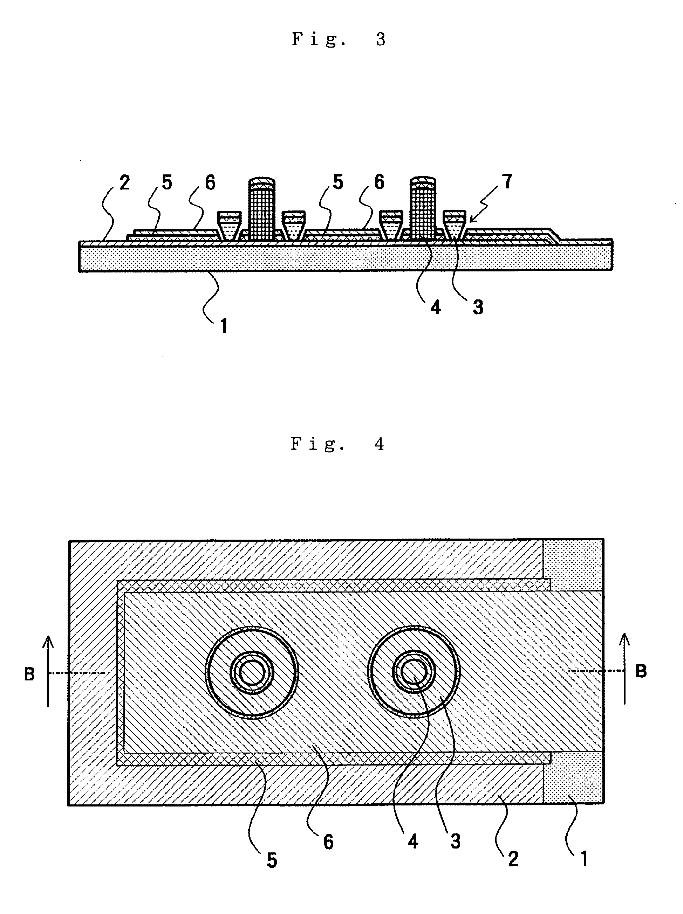

Next, FIGS. 3 and 4 are a sectional view and a top view for explaining a process subsequent to the formation of the conductive columnar member 4. FIG. 3 corresponds to the sectional view seen in the direction indicated by an arrow from a B-B line in FIG. 4.

As shown in FIGS. 3 and 4, the organic light-emitting functional layer 5 is further deposited on the transparent electrode 2. The organic light-emitting functional layer 5 is basically composed of a hole transporting layer, an organic luminous layer, and an electron injecting layer. A hole injecting layer and an electron injecting layer may additionally be provided. These layers can be deposited by a deposition technique generally used such as the spin coating method, vacuum evaporation method, etc. The thickness of each layer is appropriately determined considering the adaptability among the layers or the required total thickness. The thickness of each layer is generally set within the range of 5 nm to 5 µm.

In this case, organic materials each emitting a different color of R (red), G (green), and B (blue) are selectively deposited on a small area of the transparent electrode 2, whereby an organic EL light-emitting apparatus that can emit white color or a whitish color can be provided. This can be realized by executing a method of successively depositing the organic materials, each emitting a different color, on the different positions of the transparent electrode 2 by means of an unillustrated shadow mask.

Subsequently, the back electrode 6 that functions as a cathode electrode serving as the second electrode is deposited on the light-emitting functional layer 5. The back electrode 6 is made of a metal, alloy, or conductive compound having a small work function. Examples of the materials include aluminum, aluminum-lithium alloy, magnesium-silver alloy, etc. The thickness of the back electrode 6 is set to about 10 to 500 nm, preferably about 50 to 200 nm. The back electrode 6 can also be deposited by a method generally used, such as the sputtering method, ion plating method, deposition method, etc.

In this case, by the formation of the back electrode 6 for example by the deposition method, the back electrode 6 is deposited not only on the light-emitting functional layer 5 but also on the organic materials deposited on the top surface of the separator 3 and the columnar member 4. As previously explained, the sectional shape of the separator 3 is formed into an inverted isosceles trapezoid including the overhang portion 3a, so that it is prevented that the material of the back electrode is deposited at the root portion of the separator 3 in the deposition of the back electrode 6.

As a result, the insulating gap portion 7 can be formed around the separator 3, which can effectively prevent the formation of the electrical conductive path between the columnar member 4 connected to the transparent electrode 2 and the back electrode 6.

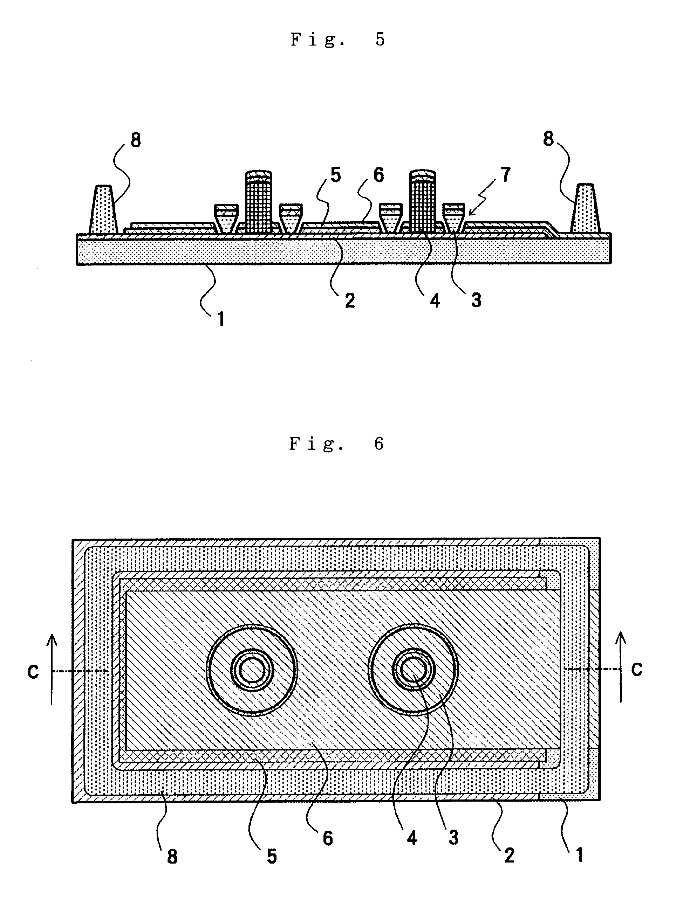

FIGS. 5 and 6 are a sectional view and a top view for explaining a process subsequent to the formation of the back electrode 6. FIG. 5 corresponds to the sectional view seen in the direction indicated by an arrow from a C-C line in FIG. 6.

As shown in FIGS. 5 and 6, after the process for depositing the back electrode 6, an adhesive for mounting a later-described sealing member to the backside of the light-emitting apparatus is applied. For the sake of convenience of the explanation, the example shown in FIGS. 5 and 6 illustrates the state in which an adhesive 8 is applied at four sides of the substrate 1 enclosing the portion including two columnar members 4. However, as specifically explained later, many columnar members 4 are arranged on the entire light-emitting apparatus.

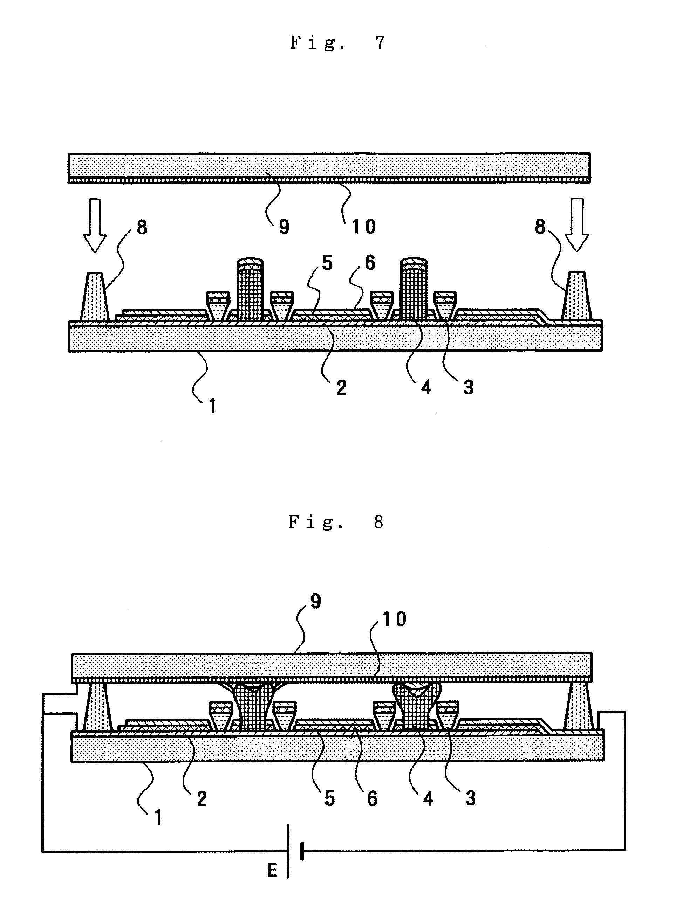

FIG. 7 shows the state in which a sealing member 9 is bonded to the backside of the light-emitting apparatus through the adhesive 8 applied on four sides of the substrate 1. The sealing member 9 in the present embodiment is made of an insulating material such as a glass. A conductive layer 10 is formed on all over the surface of the sealing member 9 opposite to the substrate 1. The sealing member 9 is bonded such that the conductive layer 10 faces the columnar members 4, which are provided upright on the transparent electrode 2, as shown in FIG. 8.

Thus, the material of the light-emitting functional layer and the material of the back electrode formed at the top of each of the columnar members 4 are crushed, resulting in that the conductive layer 10 of the sealing member 9 is electrically connected to the top of each of the columnar members 4. Accordingly, the conductive layer 10 formed on the sealing member 9 forms an electric power supply point that can supply electric power to the transparent electrode 2 through the conductive columnar members 4.

Thus, as shown in FIG. 8, the sealing member 9 seals the transparent electrode 2 as the first electrode, the organic light-emitting functional layer 5, and the back electrode 6 serving as the second electrode so as to accommodate them between the substrate 1 and the sealing member 9. Therefore, the sealing member 9 can prevent the oxidation of the organic materials laminated on the transparent electrode 2, and further, can block water contents that affects the interface between the light-emitting functional layer and the back electrode to form a dark spot. Consequently, the sealing member 9 can contribute to increase the service life of the light-emitting apparatus. It is desirable that an unillustrated drying agent and inert gas such as argon gas are sealed, as needed, in the sealed space formed between the substrate 1 and the sealing member 9.

As shown in FIG. 8, a light emission drive current is supplied from an anode terminal (+) of a DC power supply E, serving as a power supply unit, to the transparent electrode 2, i.e., to a main electric power supply point of the transparent electrode 2, and a light emission drive current from the same electrode terminal (+) of the power supply unit is supplied to the conductive layer 10 of the sealing member 9, in the EL light-emitting apparatus manufactured by the process explained above. A cathode terminal (-) of the DC power supply E is connected to the back electrode 6. Accordingly, the light emitted from the light-emitting functional layer 5 is emitted from the surface of the substrate 1 through the transparent electrode 2 and the substrate 1.

In this case, electric power can be supplied to the transparent electrode 2 from the conductive layer 10 of the sealing member 9 through the conductive columnar members 4, which are formed interspersedly in the plane direction of the substrate 1, i.e., through auxiliary electric power supply points. Therefore, the brightness unevenness produced due to the high electric resistivity of the transparent electrode represented by ITO can effectively be prevented.

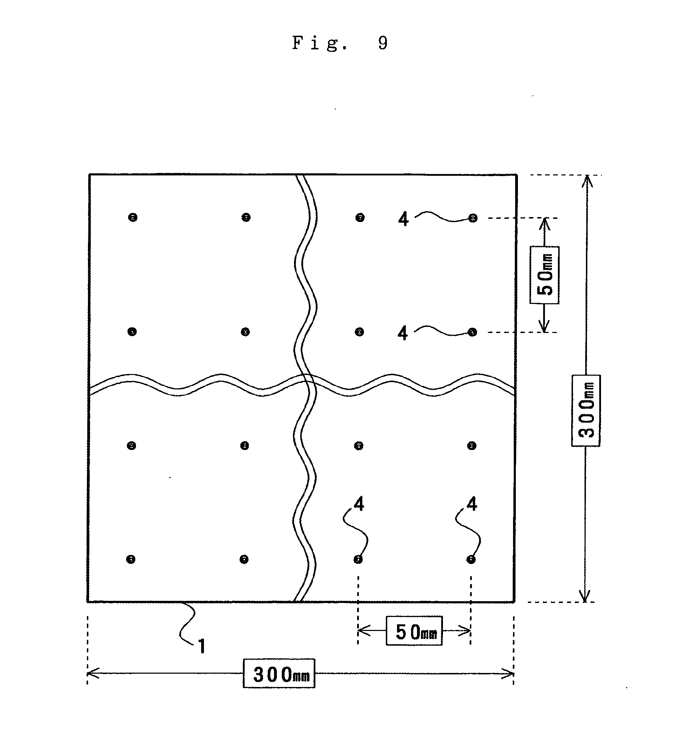

FIG. 9 is a plan view showing the example of the arrangement of the electric power supply points (identified by the numeral 4 same as the columnar members) to the transparent electrode 2 formed through the conductive columnar members 4. In the example shown in FIG. 9, the outer dimension of the substrate 1 is 300 mm × 300 mm. The electric power supply points 4 by the columnar members are formed at a space of 50 mm in the plane direction of the substrate 1.

Accordingly, the above-mentioned configuration makes it possible to extract the emission on all over the substrate 1 except for the electric power supply points 4 having small areas, whereby the extraction (take-out) efficiency of the light emission can remarkably be enhanced.

Since the light emission drive current does not flow through the light-emitting functional layer 5 at the electric power supply points 4 to the transparent electrode 2, the problem of supplying reactive current to the light-emitting functional layer can be avoided. Thus, the utilization factor of electric power can be enhanced.

In the embodiment explained above, the conductive layer 10 is formed on the sealing member 9, and electric power is supplied to the transparent electrode 2 from the conductive layer 10 through the conductive columnar members 4. However, if the sealing member is made of a conductive metallic material, the conductive layer 10 can be omitted.

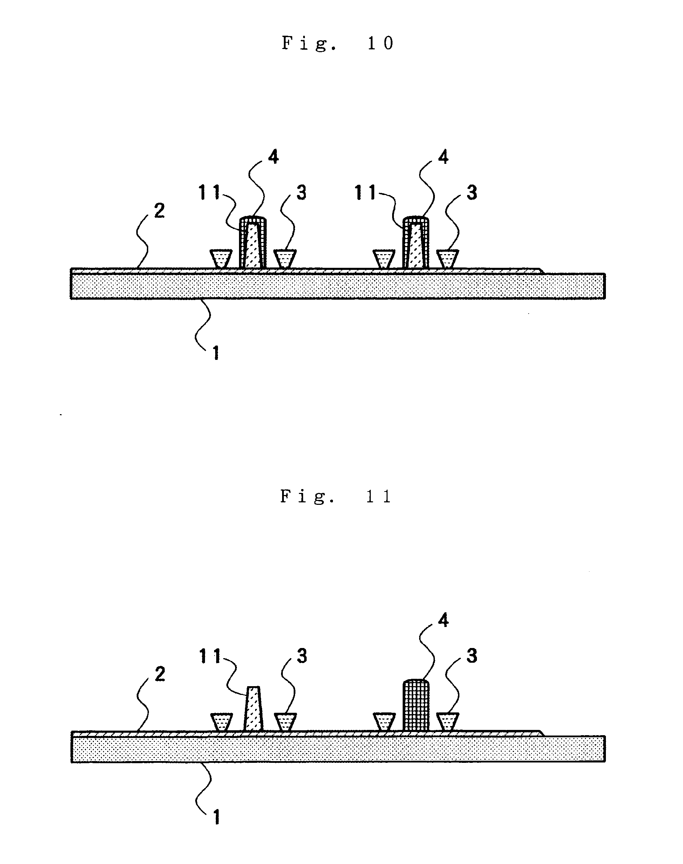

FIG. 10 is an enlarged sectional view of an essential part of the organic EL light-emitting apparatus at an initial stage of the manufacturing process according to a second embodiment of the present invention. FIG. 10 corresponds to FIG. 1 explained previously. In FIG. 10, the components having the same function as those shown in FIG. 1 are identified by the same reference numerals, and their detailed explanations are omitted.

In the configuration shown in FIG. 10, a gap holding member 11 having hardness higher than that of the conductive material formed at the peripheral portion of the columnar member 4 is accommodated at a core part of the columnar member 4 provided upright on the transparent electrode 2. In case where the columnar member 4 provided with the gap holding member 11 is used, the columnar member 4 functions as a reinforcing member for maintaining a space (gap) between the substrate 1 and the sealing member 9 with the sealing member 9 sealing as shown in FIG. 8.

FIG. 11 is an enlarged sectional view of an essential part of the organic EL light-emitting apparatus at an initial stage of the manufacturing process according to a third embodiment of the present invention. FIG. 11 corresponds to FIG. 1 explained previously. In FIG. 11, the components having the same function as those shown in FIG. 1 are identified by the same reference numerals, and their detailed explanations are omitted.

In the configuration shown in FIG. 11, a gap holding member 11 is provided upright on the transparent electrode 2 separately from the columnar member 4 provided upright on the transparent electrode 2. When the sealing member 9 seals as shown in FIG. 8 in the configuration in which the gap holding member 11 is provided upright on the transparent electrode 2, the gap holding member 11 functions as a reinforcing member for maintaining a space (gap) between the sealing member 9 and the substrate 1.

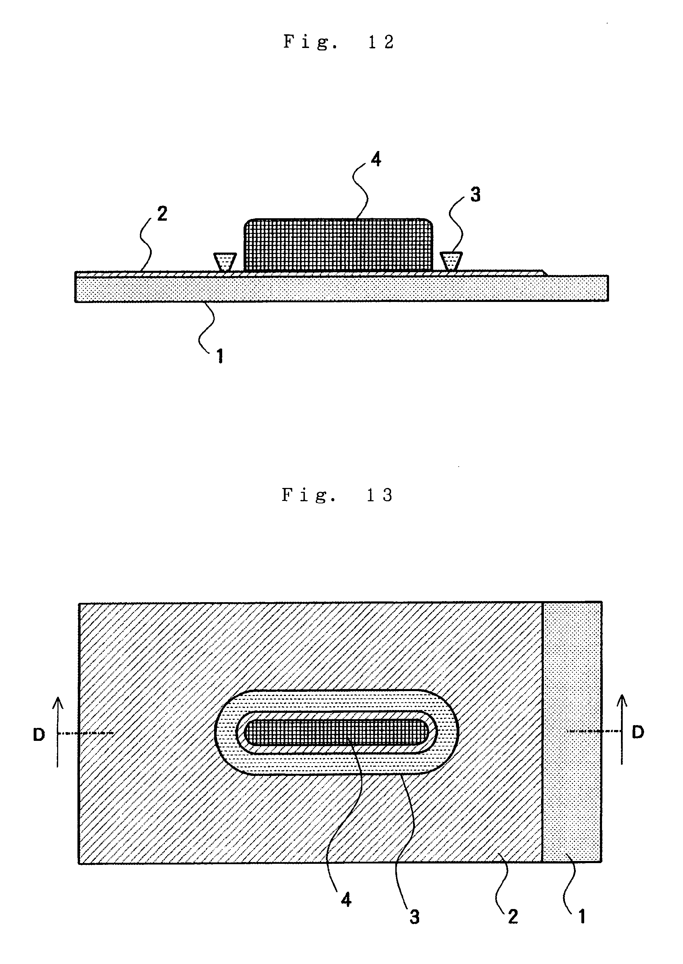

FIG. 12 is an enlarged sectional view of an essential part of the organic EL light-emitting apparatus at an initial stage of the manufacturing process according to a fourth embodiment of the present invention. FIG. 13 shows the same essential part viewed from the top. Specifically, FIG. 12 corresponds to the section seen from a direction shown by an arrow from a line D-D in FIG. 13. In FIGS. 12 and 13, the components having the same function as those shown in FIGS. 1 and 2 are identified by the same reference numerals, and their detailed explanations are omitted.

In the configuration shown in FIGS. 12 and 13, the separator 3 is formed into an elliptic shape that is long in one direction, and the columnar member 4 formed in the separator 3 is also formed into an elliptic shape that extends flatly along the longitudinal direction of the separator 3. According to this configuration, the separator 3 and the columnar member 4 are formed so as to be long in one direction, so that the width of the electric power supply portion by the columnar member 4, which does not contribute to the emission, can be reduced. Therefore, sufficient conductivity can be secured by the flat columnar member 4 without making the non-emission portion noticeable.

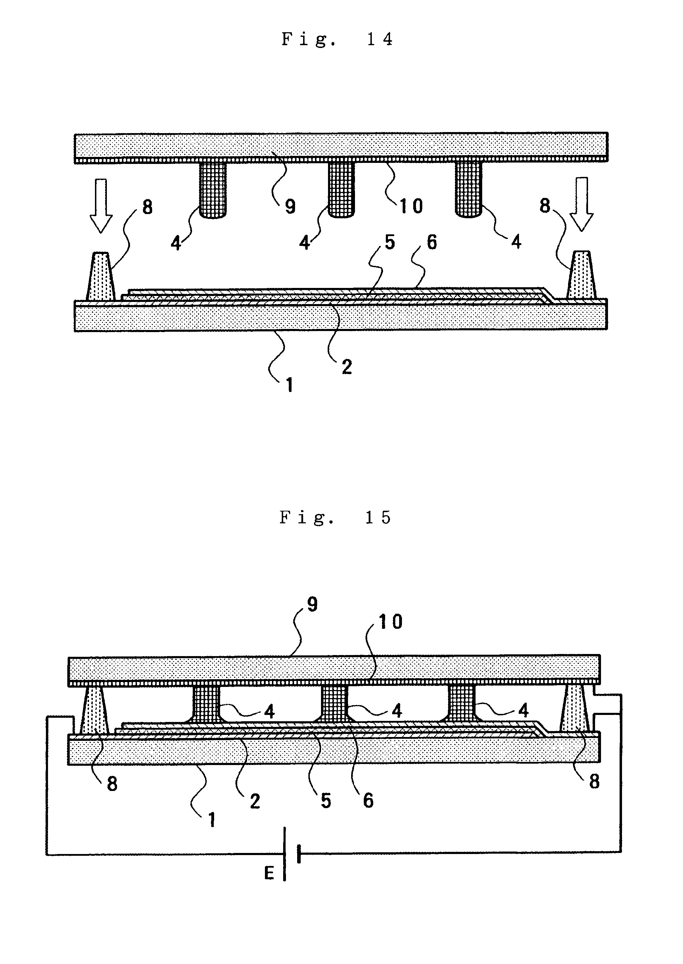

FIG. 14 shows an organic EL light-emitting apparatus according to a fifth embodiment of the present invention. In the embodiment shown in FIG. 14, the conductive columnar members 4 are formed on the conductive layer 10 of the sealing member 9. Deposited successively on the substrate 1 are the transparent electrode 2 serving as the first electrode, the light-emitting functional layer 5, and the back electrode 6 serving as the second electrode.

Specifically, in the embodiment shown in FIG. 14, electric power is supplied to the back electrode 6 serving as the second electrode through the conductive columnar members 4. There is a technical reason why the back electrode 6 must be formed thin even if a metallic material is used for the back electrode 6. Therefore, this configuration is suitably applied to the case in which the resistance value of the electrode increases. When a transparent electrode (top emission type) is used as the second electrode, the configuration shown in FIG. 14 is naturally effective, since the transparent electrode has a high resistivity.

As shown in FIG. 14, the adhesive 8 is applied to four sides of the substrate 1, and in this state, the sealing member 9 is sealed as shown in the figure. Accordingly, the leading ends of the columnar members 4 are crushed in contact with the back electrode 6, whereby auxiliary electric power supply points are formed. Thus, the EL light-emitting apparatus shown in FIG. 15 can be manufactured.

As shown in the figure, an anode terminal (+) of a DC power supply E serving as a power supply unit is connected to the first electrode 2 in the EL light-emitting apparatus shown in FIG. 15. A cathode terminal (-) of the power supply unit is connected to the second electrode 6 (the contact portion is a main electric power supply point), and the cathode terminal (-) is connected to the back electrode 6 serving as the second electrode through the conductive layer 10 of the sealing member 9 and the columnar members 4 (the contact portions are auxiliary electric power supply points).

In this case, electric power can be supplied to the second electrode 6 from the conductive layer 10 of the sealing member 9 through the conductive columnar members 4, which are formed interspersedly in the plane direction of the substrate 1, i.e., through auxiliary electric power supply points. Therefore, the brightness unevenness produced due to the high electric resistivity of the second electrode can effectively be prevented.

## Claims

1. An organic EL light-emitting apparatus including a first electrode, an organic light-emitting functional layer, and a second electrode, those of which are successively laminated on a substrate, and a sealing member that seals the first electrode, the organic light-emitting functional layer and the second electrode so as to accommodate them between the substrate and the sealing member, wherein
a main electric power supply point that supplies light emission drive current to at least one of the first electrode and the second electrode from a power supply unit and an auxiliary electric power supply point that supplies light emission drive current from the same electrode terminal of the power supply unit to at least one of the first electrode and the second electrode through the sealing member are provided.

2. An organic EL light-emitting apparatus including a first electrode, an organic light-emitting functional layer, and a second electrode, those of which are successively laminated on a substrate, and a sealing member that seals the first electrode, the organic light-emitting functional layer and the second electrode so as to accommodate them between the substrate and the sealing member, wherein
the sealing member is made of a conductive material, or a conductive layer made of a conductive material is formed on the sealing member, and conductive columnar members are interspersedly formed in the plane direction of the substrate between the sealing member or the conductive layer formed on the sealing member and the first electrode or the second electrode, wherein
a light emission drive current from a power supply unit is fed to the first electrode or the second electrode, and the light emission drive current from the same electrode terminal of the power supply unit is fed to the first electrode or the second electrode through the sealing member or the conductive layer formed on the sealing member and the conductive columnar members.

3. An organic EL light-emitting apparatus according to claim 2,
wherein
an annular separator is formed to project from the first electrode so as to enclose the surroundings of the columnar members, and an insulating gap portion for inhibiting the formation of an electrical conductive path by the material of the second electrode is formed between the columnar members and the second electrode when laminating the second electrode.

4. An organic EL light-emitting apparatus according to claim 3, wherein
the separator is provided with an overhang portion whose top projects toward the direction parallel to the substrate.

5. An organic EL light-emitting apparatus according to any one of claims 1 to 4, wherein
a gap holding member having a hardness greater than that of the conductive material constituting the columnar member is provided at an axial core portion of the columnar member for maintaining the space between the substrate and the sealing member.

6. An organic EL light-emitting apparatus according to any one of claims 2 to 4, wherein
a gap holding member for maintaining the space between the substrate and the sealing member is provided separately from the columnar member.

7. A method of manufacturing an organic EL light-emitting apparatus including a first electrode, an organic light-emitting functional layer, and a second electrode, those of which are successively laminated on a substrate, and a sealing member provided at its backside, the method comprising:
a step of forming the first electrode on the substrate;
a step of forming on the first electrode annular separators interspersedly in the plane direction of the substrate so as to project from the first electrode in the normal direction of the substrate, and forming conductive columnar members on the first electrode at the center of each of the separators;
a step of depositing an organic ELmediumon the first electrode, the columnar members and the separators so as to form the organic light-emitting functional layer;
a step of forming the second electrode on the organic light-emitting functional layer; and
a step of sealing the sealing member so as to accommodate the first electrode, the organic light-emitting functional layer, and the second electrode between the substrate and the sealing member,
wherein
an electric power supply point to the first electrode is formed by the sealing member made of a conductive material or a conductive layer formed on the sealing member through the conductive columnar members.

8. A method of manufacturing an organic EL light-emitting apparatus according to claim 7, further comprising a step of forming, on the annular separator, an overhang portion that projects toward the normal direction of the substrate and has the top portion projecting in the direction parallel to the substrate.
